Europäisches Patentamt

European Patent Office

Office européen des brevets

(11) Veröffentlichungsnummer: **0 348 680**

**A2**

## EUROPÄISCHE PATENTANMELDUNG

(21) Anmeldenummer: 89109901.2

(22) Anmeldetag: 01.06.89

(51) Int. Cl.⁴: **H03J 5/24**

(30) Priorität: 28.06.88 DE 3821716

(43) Veröffentlichungstag der Anmeldung:
03.01.90 Patentblatt 90/01

(84) Benannte Vertragsstaaten:
**DE FR GB IT NL**

(71) Anmelder: **TELEFUNKEN electronic GmbH**
**Theresienstrasse 2**
**D-7100 Heilbronn(DE)**

(72) Erfinder: **Heigl, Franz**
**Frühlingstrasse 12**
**D-8079 Ochsenfeld(DE)**
Erfinder: **Küspert, Ludwig**
**Austrasse 7**
**D-8079 Hofstetten(DE)**

(74) Vertreter: **Maute, Hans-Jürgen, Dipl.-Ing.**
**TELEFUNKEN electronic GmbH**
**Theresienstrasse 2**
**D-7100 Heilbronn(DE)**

(54) **Fernsehtuner mit einer Bandfilterschaltung.**

(57) Ein Fernsehtuner für wenigstens zwei Frequenzbänder weist einen gemeinsamen Vorverstärker (15) auf, an dessen Ausgang eine schaltbare und durchstimmbare Bandfilterschaltung (19,21) für die beiden Frequenzbänder, die vorzugsweise von VHF-Band I bis einschließlich Hyperband reichen, angeschlossen ist. Damit bei einfachem Schaltungsaufbau und geringem Platzbedarf eine hohe Selektionswirkung erreicht wird, ist an den Ausgang (16) des Vorverstärkers (15) eine zweistufige Umschalteinrichtung (17) angeschlossen, an die getrennte Eingänge (20) von eigenständigen Bandfiltern (19,21) angeschaltet sind.

FIG.3

EP 0 348 680 A2

## Fernsehtuner mit einer Bandfilterschaltung

Die Erfindung betrifft einen Fernsehtuner gemäß dem Oberbegriff des ersten Anspruchs.

Bei einem bekannten Fernsehtuner dieser Art (DE-PS 29 29 901) ist an einem gemeinsamen Antennenanschluß ein umschaltbares Vorkreisfilter vorgesehen, dessen Ausgang an einem gemeinsamen Vorverstärker angeschlossen ist. Dem Ausgang des Vorverstärkers ist eine umschaltbare, ebenfalls für zwei Frequenzbereiche ausgebildete Bandfilterschaltung nachgeschaltet, deren Schwingkreise jeweils zwei in Serie geschaltete Spulen aufweisen, von welchen über gleichstromgesteuerte Bandschaltdioden eine Spule kurzschließbar ist. Der gemeinsame Ausgang der Bandfilterschaltung ist an eine Mischschaltung angeschlossen. Für das Umschalten einer kombinierten Bandfilterschaltung sind demnach zwei Schaltelemente erforderlich, für die auch entsprechende Gleichstromversorgungspfade bereitgestellt werden müssen. Dabei stellen diese Schaltdioden kapazitive und ohmsche Belastungen dar, die nicht nur die Selektion nachteilig beeinflußen, sondern auch den Frequenzdurchstimmbereich einengen, so daß ein Abstimmen innerhalb eines das VHF-Band I bis einschließlich Hyperband umschließendes Frequenzband mit dieser Schaltungsanordnung nicht überstrichen werden kann.

Der Erfindung liegt die Aufgabe zugrunde, bei einem Fernsehtuner gemäß dem Oberbegriff des ersten Anspruchs Maßnahmen zu treffen, durch die bei einfachem Aufbau eine hohe Selektionswirkung über einen durchgehenden, weiten Frequenzbereich erzielt wird.

Die Lösung dieser Aufgabe erfolgt gemäß der Erfindung durch die kennzeichnenden Merkmale des ersten Anspruchs.

Bei einem Aufbau eines Tuners gemäß der Erfindung wird durch die zweistufige Umschalteinrichtung und die beiden separaten Bandfilter erreicht, daß die für die Umschaltung erforderlichen Bauelemente nicht im eigentlichen Schwingkreis des jeweiligen Bandfilterkreises liegen, so daß der Durchstimmbereich sowie die Schwingkreisgüte und damit der Selektionsfaktor nicht nachteilig beeinträchtigt werden. Zudem kann jedes Bandfilter optimal für das bestimmungsgemäße Frequenzband bemessen werden, so daß Bemessungskompromisse nicht erforderlich sind. Insbesondere läßt sich dadurch der gesamte Frequenzbereich von VHF-Band I bis einschließlich Hyperband mit nur zwei abstimmbaren Bandfiltern selektiv durchstimmen. wobei ein Frequenzband z. B. von 50 MHz bei 150 MHz und der andere von 150 MHz bis 470 MHz reichen kann. Vorzugsweise ist an den Ausgang des Vorverstärkers einerseits das Bandfilter für den hohen Frequenzbereich über einen Kondensator und andererseits das Bandfilter für den tiefen Frequenzbereich über die Reihenschaltung aus einer Spule und einem Kondensator angeschaltet, wobei zwischen dem Verbindungspunkt der Hochpaßspule mit dem Tiefpaßkondensator und Massepotential eine einzige Bandschaltdiode liegt. Bei geöffnetem Bandschalter ist dann das Bandfilter für den hohen Frequenzbereich so weit verstimmt, daß eine Selektion auf der Empfangsfrequenz praktisch nicht mehr eintritt, während das Bandfilter für den tiefen Frequenzbereich optimal über den Tiefpaß an die Vorstufe angekoppelt ist. Bei geschlossenem Bandschalter dagegen ist der Eingang des Bandfilters für den tiefen Frequenzbereich hochfrequenzmäßig kurzgeschlossen, wobei die Spule 40 und der Kondensator 39 einen für den hohen Frequenzbereich bemessenen Hochpaß bilden, über den das Bandfilter für den hohen Frequenzbereich an den Vorverstärker so angepaßt ist, daß es seine optimale Selektionswirkung erreicht.

Andere vorteilhafte Weiterbildungen der Erfindung sind in den übrigen Ansprüchen angegeben.

Die Erfindung ist nachfolgend anhand der Schaltungsskizzen eines Ausführungsbeispiels näher erläutert.

Es zeigt:

Figur 1 ein Blockschaltbild eines gemäß der Erfindung aufgebauten Tuners,

Figur 2 eine Schaltung der hochfrequenzmäßig wirksamen Bauteile des Vorselektionsteils,

Figur 3 eine Schaltungsanordnung zur Anschaltung von Bandfiltern an die Vorstufe und

Figur 4 die mit Gleichstromwegen ergänzte Schaltungsanordnung nach Figur 3.

Ein Fernsehtuner ist mit einem gemeinsamen Antennenanschluß 1 ausgestattet, von dem ein erster Bereichsumschalter 2 zu einem Tunerzweig für die Frequenzen des VHF-Bandes I bis einschließlich Hyperband und ein zweiter Bereichsumschalter 3 zu ein m UHF-Tunerzweig führen. Der UHF-Tunerzweig ist aus einem Vorkreisfilter 4 mit nachfolgendem Vorverstärker 5 und daran anschließendem Bandfilter 6 mit nachfolgender Mischstufe 7 gebildet, der ein eigenständiger Oszillator 8 zugeordnet ist.

Die UHF-Mischstufe 7 ist mit einem Zwischenfrequenzkreis 9 gekoppelt, dem ein Zwischenfrequenzverstärker 10 mit einem Zwischenfrequenzausgang 11 nachfolgt.

An den ersten Bereichsumschalter 2 ist dagegen ein Vorkreisfilter 12 angeschlossen, das auf einen niedrigen und einen direkt anschließenden höheren Frequenzbereich umschaltbar ist. Dieses für die beiden Frequenzbereiche kombinierte Vorkreisfilter 12 ist mit seinem gemeinsamen Filterausgang 13 an den Eingang 14 eines gemeinsamen Vorverstärkers 15 angeschaltet. Der Ausgang 16 des Vorverstärkers 15 liegt an einer zweistufigen Umschalteinrichtung 17, an deren Ausgänge einerseits der Eingang 18 eines für den tiefen Frequenzbereich bemessenen Bandfilters 19 und an dessen anderen Ausgang der Eingang 20 eines für den hohen Frequenzbereich bemessenen Bandfilters 21 angeschlossen ist. Die Umschaltung des Vorkreisfilters und der Umschalteinrichtung 17 erfolgt jeweils gleichzeitig über eine strichpunktiert angedeutete Schaltverbindung 22 abhängig vom ausgewählten Frequenzbereich. Die Ausgänge 23 bzw. 24 der Bandfilter 19 bzw. 21 sind jeweils auf eine eigenständige Mischstufe 25 bzw. 26 geschaltet. Auch den Mischstufen 25 und 26 ist je ein eigener Oszillator 27 bzw. 28 zugeordnet. Ferner sind die Mischstufen 25 und 26 unabhängig voneinander an den gemeinsamen Zwischenfrequenzkreis 9 angeschlossen. Die Mischstufen und Oszillatoren sind Teil einer integrierten Tunerschaltung 29, beispielsweise vom Typ TDA 5330 T oder TUA 2007. Die getrennten Bandfilter 19 bzw. 21 ermöglichen dabei eine sehr hohe Empfangsempfindlichkeit bei großer Störsicherheit, weil sie optimal für den entsprechenden Frequenzbereich bemessen sein können und keine die Selektion und den Durchstimmbereich beeinflussenden Schaltdioden erfordern. Es sind daher auch keine gesonderten Umschaltspannungen für die Schaltdioden erforderlich. Zur hohen Selektion und Störsicherheit trägt auch die jeweils eigenständig Mischstufe bei, so daß übliche Kompromisse für die Mischstufenbeschaltung entfallen.

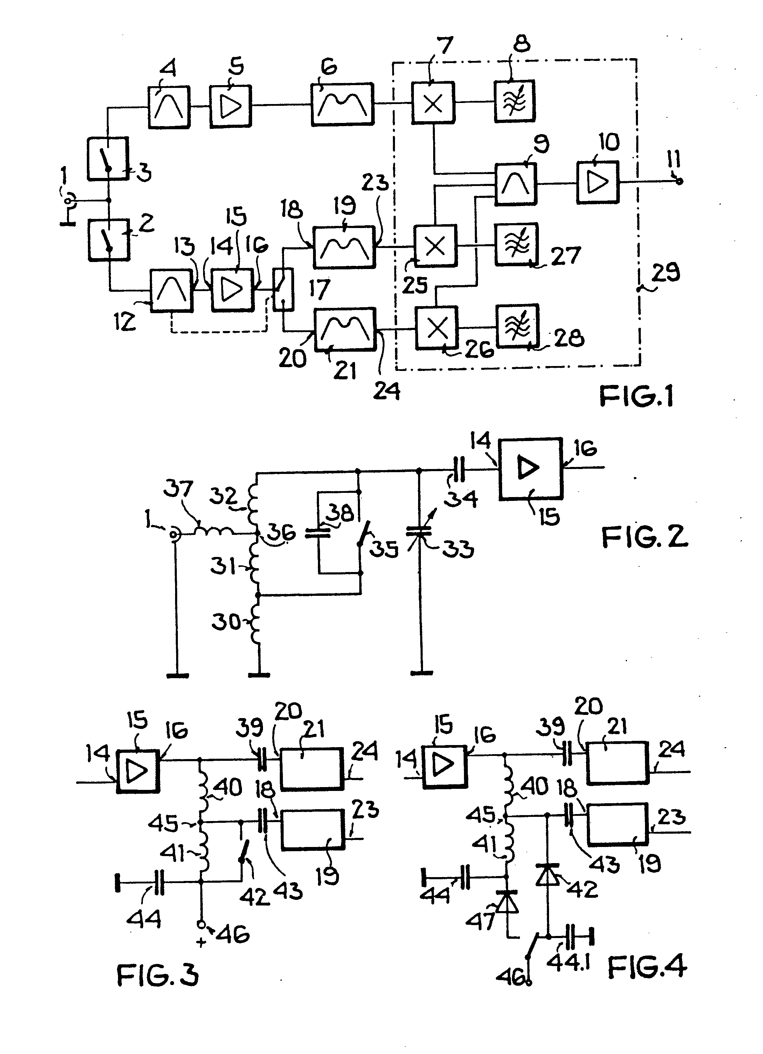

Die Vorkreis- und Vorverstärkerschaltung ist ohne Berücksichtigung des ersten Bereichsumschalters 2 in Figur 2 dargestellt. Das Vorkreisfilter besteht demnach aus der Serienschaltung von drei frequenzbestimmenden Spulen 30, 31, 32, zu welchen ein gemeinsamer frequenzbestimmer Kondensator 33 vorzugsweise in Form einer spannungssteuerbaren Kapazitätsdiode parallel geschaltet ist. Die erste Spule 30 ist dabei einseitig an Massepotential und die dritte Spule 32 über einen Trennkondensator 34 an den Eingang 14 des Vorverstärkers 15 angeschlossen. Parallel zur Serienschaltung aus der zweiten und der dritten Spule 31 bzw. 32 liegt dagegen ein Bereichschalter 35, der insbesondere als gleichstrommäßig steuerbare Schaltdiode ausgebildet ist. Vom Verbindungspunkt 36 zwischen der zweiten und der dritten Spule 31 bzw. 32 führt eine Anpassungsspule 37 zum Antennenanschluß 1. In der dargestellten Schaltstellung gemäß Figur 2 ist das Vorkreisfilter 12 für den niedrigen Frequenzbereich bemessen, der von zirka 50 bis 150 MHz reicht. Innerhalb dieses Frequenzbereichs ist die Anpassungsspule 37 besonders bei den niedrigen Frequenzen weitgehend ohne Wirkung. Die Grund-Anpassung erfolgt hier durch das Teilungsverhältnis der Induktivitätswerte der Spulen 30, 31 und 32. Durch die Kapazitätsvariation des Kondensators 33 läßt sich so der niedrige Frequenzbereich durchstimmen, in dem alle drei Spulen 30, 31 und 32 frequenzbestimmend sind. Da der Frequenzvariationsbereich im niedrigen Frequenzbereich etwas kleiner ist als im hohen Frequenzbereich, der von zirka 150 bis 470 MHz reicht, kann parallel zum Bereichschalter 35 ein Korrekturkondensator 38 geschaltet werden, der den wirksamen Variationsbereich des Kondensators 33 bei geöffnetem Bereichsschalter (35) im erforderlichen Maß begrenzt. Der Bereichschalter (35) dient so gleichzeitig zur Änderung des Durchstimmverhältnisses.

Wird der Bereichschalter 35 geschlossen, dann ist allein die Spule 30 unmittelbar parallel zum Kondensator 33 geschaltet und bestimmt so den hohen Frequenzbereich. Bei geschlossenem Bereichschalter 35 ist auch der Korrekturkondensator 38 kurzgeschlossen und damit der Kondensator 33 mit seinem gesamten Variationsbereich allein frequenzbestimmend. Zusätzlich wird bei geschlossenem Bereichschalter 35 auch die Serienschaltung aus den Spulen 31 und 32 zu einer Parallelschaltung, die in Serie mit der Anpassungsspule 37 liegt. Die Spulen 31, 32 und 37 dienen dann gemeinsam der Anpassung des Vorkreisfilterkreises an den Wellenwiderstand der Antennenleitung, wobei dann für den Abgleich der Anpassung die Anpassungsspule 37 in ihrem Induktivitätswert verändert werden kann. Diese Änderung wirkt sich im niedrigeren Frequenzbereich praktisch nicht aus. Auch beeinflußt eine für den Abgleich des Schwingkreises gegebenenfalls vorzunehmende Änderung des Induktivitätswerts der Spule 30 die Schwingfrequenz des gesamten Schwingkreises im niedrigeren Frequenzbereich nur unerheblich, weil der Induktivitätswert der Spule 30 im Vergleich zum Gesamtinduktivitätswert der Spulen 31 und 32 klein ist. Diese Vorkreisschaltung erfordert auch nur einen gemeinsamen Vorverstärker 15, so daß mit nur einem Bereichschalter 35 eine Frequenzbereichumschaltung, eine Änderung des Abstimmverhältnisses und eine Umschaltung der Anpassung in den Frequenzbereichen erfolgt. Für diese minimale Zahl an Bauteilen ist somit auch nur ein entsprechend kleiner Raum im Tunergehäuse erforderlich, ohne die Selektion, den Durchstimmbereich und die Störsicherheit nachteilig zu beeinflussen.

An den Ausgang 16 des Vorverstärkers 15 ist die Umschalteinrichtung 17 für die Bandfilter 19 bzw. 21 angeschlossen, wobei die Umschalteinrichtung einen Kondensator 39 aufweist, der vom Ausgang 16 an den Eingang 20 des Bandfilters 21 für den hohen Frequenzbereich geschaltet ist. Eine Spule 40 führt vom Ausgang 16 über die Parallelschaltung aus einer Hochfrequenzdrossel 41 sowi einem Bandschalter 42 zu einer Stromversorgungsquelle 46 bzw. über einen Tiefpaßkondensator 43 zum Eingang 18 des Bandfilters 19 für den tiefen Frequenzbereich. Der Bandschalter 42 ist wie die Hochfrequenzdrossel 41 über einen Abblockkondensator 47 hochfrequenzmäßig an Massepotential angeschaltet. Bei geschlossenem Bandschalter 42, der vorzugsweise ebenfalls eine Schaltdiode ist und zusammmen mit dem Bereichsschalter 35 gesteuert wird, bildet der Hochpaßkondensator 39 mit der Hochpaßspule 40 einen Bandpaß für den hohen Frequenzbereich, wobei der

Verbindungspunkt 45 der Spule 40 mit dem Kondensator 43 über den Bandschalter 42 an Massepotential angeschlossen ist. Das Bandfilter für den tiefen Frequenzbereich ist somit hochfrequenzmäßig, eingangsseitig und kurzgeschlossen. Das Hochpaßfilter 39, 40 ermöglicht somit eine optimale Anpassung zwischen dem Vorverstärker 15 und dem Bandfilter 21.

Bei nicht leitendem, also offenem Bandschalter 42 bildet dagegen die Spule 40 mit dem Kondensator 43 einen Tiefpaß gebildet durch Kondensator 39, über der Eingangsimpedanz des Bandfilters 21 geerdet ist, für den tiefen Frequenzbereich, wobei das angeschaltete Bandfilter 19 das noch über den Kondensator 39 angekoppelte Bandfilter 21 für den hohen Frequenzbereich so weitgehend verstimmt, daß auch dort eine Selektion bestimmter Frequenzen nicht mehr möglich ist.

Durch die Hochfrequenzdrossel 41 ist bei geöffnetem Bandschalter 42 ein Gleichstromweg zum Ausgang 16 des Verstärkers 15 gegeben, so daß über diesen Weg das im Vorverstärker 15 vorhandene Verstärkerelement mit Gleichstrom versorgt werden kann, ohne den Tiefpaß zu beeinflussen.

In Figur 4 ist eine Schaltungsanordnung gemäß Figur 3 dargestellt, bei der als Bandschalter eine Schaltdiode 42 verwendet ist. Dort ist bei sonst gleichem Schaltungsaufbau in Serie mit der Hochfrequenzdrossel eine einfache Diode 47 vorgesehen, über welche die Gleichstromspeisung des Vorverstärkers 15 erfolgt, wenn der niedrige Frequenzbereich eingeschaltet sein soll. In diesem Falle ist die Schaltdiode 42 stromlos und damit gesperrt, der Bereichschalter also offen. Wird dagegen die Schaltdiode 42 an die Gleichstromquelle 46 angeschaltet, dann bewirkt der sie durchfließende Strom das Durchschalten, wodurch der Bandschalter geschlossen ist. Die Schaltungsanordnung ist dann für den hohen Frequenzbereich umgeschaltet, nachdem dann der Verbindungspunkt 45 über die Schaltdiode 42 und den zugeordneten Abblockkondensator 44.1 an Massepotential liegt. Bei der Umschalteinrichtung 17 liegt die Schaltdiode 42 bzw. der Bandschalter weder in einem frequenzbestimmenden Schwingkreis noch im Hochfrequenzpfad vom Vorverstärker 15 zu den Bandfiltern 19,21, so daß sie die Selektion und die durchstimmbare Bandbreite nachteilig beeinflussende Wirkungen nicht ausübt.

## Ansprüche

1. Fernsehtuner für wenigstens zwei Frequenzbänder mit einem gemeinsamen Vorverstärker und einer an dessen Ausgang angeschlossenen, schaltbaren und durchstimmbaren Bandfilterschaltung für die beiden Frequenzbänder, vorzugsweise für den Frequenzbereich von VHF-Band I bis einschließlich Hyperband, dadurch gekennzeichnet, daß an den Ausgang (16) des Vorverstärkers (15) eine zweistufige Umschalteinrichtung (17) angeschlossen ist, an die getrennte Eingänge (18,20) von eigenständigen Bandfiltern (19,21) angeschaltet sind.

2. Fernsehtuner nach Anspruch 1 oder einem der folgenden, dadurch gekennzeichnet, daß an den Ausgang (16) des Vorverstärkers (15) einerseits das Bandfilter (21) für den hohen Frequenzbereich über einen Kondensator (39) und andererseits das Bandfilter (19) für den tiefen Frequenzbereich über die Reihenschaltung aus einer Spule (40) und einem Kondensator, gebildet aus dem Kondensator (39) und der Eingangsimpedanz des Bandfilters (21), angeschaltet ist und daß zwischen dem Verbindungspunkt (45) der Spule (40) mit dem Kondensator (43) und Massepotential ein Bandschalter (42) liegt.

3. Fernsehtuner nach Anspruch 2, dadurch gekennzeichnet, daß bei geschlossenem Bandschalter (42) der Kondensator (39) mit der Spule (40) einen Hochpaß für den hohen Frequenzbereich bildet und das Bandfilter (19) für den niedrigen Frequenzbereich eingangsseitig kurzgeschlossen ist.

4. Fernsehtuner nach Anspruch 2 oder 3, dadurch gekennzeichnet, daß bei nichtleitendem Bandschalter (42) die Spule (40) mit dem Kondensator, gebildet aus dem Kondensator (39) und der Eingangsimpedanz des Bandfilters (21), einen Tiefpaß für den tiefen Frequenzbereich bildet und das Bandfilter (21) für den hohen Frequenzbereich verstimmt ist.

5. Fernsehtuner nach Anspruch 2,3 oder 4, dadurch gekennzeichnet, daß parallel zum Bandschalter (42) eine Hochfrequenzdrossel (41) liegt, die einseitig an eine Gleichstromquelle (46) angeschlossen ist und daß der Ausgang (16) des Vorverstärkers (15) gleichstrommäßig mit dem aktiven Verstärkerelement verbunden ist.

6. Fernsehtuner nach Anspruch 2,3 oder 4, dadurch gekennzeichnet, daß der Verbindungspunkt (45) der Spule (40) mit dem Kondensator (43) einerseits über den Bandschalter (42) und einen Abblockkondensator (44) hochfrequenzmäßig an Massepotential und gleichstrommäßig über eine Schaltecke an eine Spannungsquelle (46) und andererseits über die Serienschaltung aus einer Hochfrequenzdrossel (41), einer Diode (48) und einer weiteren Schaltstrecke an eine Spannungsquelle (46) anschaltbar ist.

7. Fernsehtuner nach Anspruch 1 oder einem der folgenden, dadurch gekennzeichnet, daß die Umschalteinrichtung (17) gemeinsam mit einem Bereichschalter (35) umgeschaltet wird, der einem auf die beiden Frequenzbänder umschaltbaren Vorkreisfilter (12) zugeordnet ist.

8. Fernsehtuner nach Anspruch 7, dadurch gekennzeichnet, daß das Vorkreisfilter (12) eine Serienschaltung von drei frequenzbestimmenden Spulen (30,31,32) aufweist, zu welchen ein gemeinsamer frequenzbestimmender Kondensator (33) parallel geschaltet ist, daß die erste Spule (30) an Massepotential und die dritte Spule (32) über einen Ankoppelkondensator (34) an den Eingang (14) des Vorverstärkers (15) angeschlossen ist, daß parallel zur Serienschaltung aus der zweiten und der dritten Spule (31 bzw. 32) ein Bereichschalter (35) liegt, daß an den Verbindungspunkt (36) zwischen der zweiten und der dritten Spule (31 bzw. 32) eine Anpassungsspule (37) angeschaltet ist, die andererseits mit einem Antennenanschluß (1) verbunden ist und daß die erste Spule (30) frequenzbestimmend für den hohen Frequenzbereich ist.

9. Fernsehtuner nach Anspruch 7 oder 8, dadurch gekennzeichnet, daß das Vorkreisfilter (12) abstimmbar ist.

10. Fernsehtuner nach Anspruch 8 oder 9, dadurch gekennzeichnet, daß die Anpassungsspule (37) für den hohen Frequenzbereich bemessen ist.

11. Fernsehtuner nach Anspruch 7 oder einem der folgenden, dadurch gekennzeichnet, daß parallel zum Bereichschalter (35) ein Korrekturkondensator (38) liegt.

12. Fernsehtuner nach Anspruch 1 oder einem der folgenden, dadurch gekennzeichnet, daß die Ausgänge der Bandfilter (19,21) je an eine eigene Mischstufe (25,26) angeschlossen sind.

13. Fernsehtuner nach Anspruch 8 oder einem der folgenden, dadurch gekennzeichnet, daß zwischen den Antennenanschluß (1) und das Vorkreisfilter (12) ein erster Bereichsumschalter (2) gelegt ist, daß an den Antennenanschluß (1) ein zweiter Bereichsumschalter (3) angeschlossen ist, der einem UHF-Tunerzweig vorgeschaltet ist und daß der Ausgang der Mischstufe (7) des UHF-Tunerzweiges zusammen mit den Ausgängen der anderen Mischstufen (25,26) an einen Zwischenfrequenz-Selektor (9) angeschlossen ist, der einen gemeinsamen Zwischenfrequenzausgang (11) aufweist.

FIG.1

FIG.2

FIG.3

FIG.4